# EUROPEAN PATENT APPLICATION

(11) **EP 4 589 315 A1**
(43) Date of publication of application: **23.07.2025**
(21) Application number: 23865865.2
(22) Date of filing: 14.09.2023
(51) Int. Cl.: G01R 31/367, G01R 31/371, G01R 31/396, B60L 58/10

(54) **DATA COLLECTION APPARATUS MOUNTED ON VEHICLE AND FUNCTION CHANGE METHOD THEREOF**

(30) Priority: 16.09.2022 KR 20220117483
(71) Applicant: LG Energy Solution, Ltd., Seoul 07335 (KR)
(72) Inventor: SEO, Seung Yeop, Daejeon 34122 (KR); BAEK, Jong Shik, Daejeon 34122 (KR); JO, Jeong Jae, Daejeon 34122 (KR)
(74) Representative: Goddar, Heinz J.
(86) International application number: PCT/KR2023/013818
(87) International publication number: WO 2024/058569

(57) **Abstract**

A function changing method of a data collection apparatus mounted on a vehicle according to the present disclosure includes receiving, from the data collection apparatus, a request for a setting value of a particular function item indicating one of functions of the data collection apparatus, searching for the setting value of the particular function item by referring to a device function table, and transmitting, to the data collection apparatus, a response including the setting value of the particular function item.

## Description

### [TECHNICAL FIELD]

### CROSS-REFERENCE TO RELATED APPLICATION

This application claims priority to and the benefit of Korean Patent Application No. 10-2022-0117483 filed in the Korean Intellectual Property Office on September 16, 2022, the entire content of which is incorporated herein by reference.

### TECHNICAL FIELD

Embodiments disclosed herein relate to a data collection apparatus mounted on a vehicle to collect data regarding the vehicle, and a function changing method of the data collection apparatus.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

For battery state analysis, a separate data collection apparatus may be used. The data collection apparatus may be connected to a battery or a battery pack including the battery to collect data regarding a state of the battery, and transmit the collected data to a server to analyze the state of the battery. Meanwhile, to change a function of the data collection apparatus, a procedure for re-installing and rebooting firmware for driving the data collection apparatus is required, such that it is practically impossible to change a function of the data collection apparatus in real time.

### [DISCLOSURE]

### [TECHNICAL PROBLEM]

Embodiments disclosed herein aim to provide a data collection apparatus mounted on a vehicle in which a function of the data collection apparatus is changeable without firmware update, and a function changing method of the data collection apparatus.

Technical problems of the embodiments disclosed herein are not limited to the above-described technical problems, and other unmentioned technical problems would be clearly understood by one of ordinary skill in the art from the following description.

### [TECHNICAL SOLUTION]

A function changing method of a data collection apparatus mounted on a vehicle according to an embodiment of the present disclosure includes receiving, from the data collection apparatus, a request for a setting value of a particular function item indicating one of functions of the data collection apparatus, searching for the setting value of the particular function item by referring to a device function table, and transmitting, to the data collection apparatus, a response including the setting value of the particular function item.

According to an embodiment, the device function table may include function setting data where a target item indicating identification information of the data collection apparatus, a function item including the particular function item, a type item indicating a type of data, and a setting value of the function item are matched to one another.

According to an embodiment, the searching for the setting value of the particular function item may include searching for the identification information of the data collection apparatus in the target item, searching for the particular function item in the function item, and searching for a first type indicating a setting value in the type item.

According to an embodiment, the function changing method may further include receiving, from the data collection apparatus, a request for a state value of the particular function item and searching for the state value of the particular function item by referring to the device function table.

According to an embodiment, the device function table may include function state data where a target item indicating identification information of the data collection apparatus, a function item including the particular function item, a type item indicating a type of data, and a state value of the function item are matched to one another.

According to an embodiment, the searching for the setting value of the particular function item may include searching for the identification information of the data collection apparatus in the target item, searching for the particular function item in the function item, and searching for a second type indicating a state value in the type item.

According to an embodiment, the request for the state value of the particular function item may include an application value of the particular function item, stored in the data collection apparatus.

According to an embodiment, the function changing method may further include comparing the application value of the particular function item with the state value of the particular function item, stored in the device function table and updating the state value of the particular function item into the application value of the particular function item, when the application value of the particular function item and the state value of the particular function item are different from each other.

According to an embodiment, the function changing method may further include analyzing vehicle state information received from the data collection apparatus to determine whether function change of the particular function item of the data collection apparatus is required, and changing a setting value corresponding to the data collection apparatus and the particular function item in the device function table, when the function change is required.

A function changing method of a data collection apparatus mounted on a vehicle according to another embodiment of the present disclosure includes transmitting, to a server managing the data collection apparatus, a request for a setting value of a particular function item indicating one of functions of the data collection apparatus, receiving, from the server, a response including the setting value of the particular function item, and reflecting the setting value of the particular function item to a function application table.

According to an embodiment, the function application table may include function state data where a target item indicating identification information of the data collection apparatus, a function item including the particular function item, and an application value of the function item are matched to one another.

According to an embodiment, the function changing method may further include comparing the setting value of the particular function item with the application value of the particular function item, stored in the function application table and updating the setting value of the particular function item into the application value of the particular function item, when the setting value of the particular function item and the application value of the particular function item are different from each other.

According to an embodiment, the function changing method may further include performing a function corresponding to the particular function item by referring to the application value of the particular function item, stored in the function application table.

A data collection apparatus mounted on a vehicle according to an embodiment of the present disclosure includes a wireless communication unit configured to transmit, to a server managing the data collection apparatus, a request for a setting value of a particular function item indicating one of functions of the data collection apparatus, and receive, from the server, a response including the setting value of the particular function item, a function storage unit configured to store a function application table including function state data where a target item indicating identification information of the data collection apparatus, a function item including the particular function item, and an application value of the function item are matched to one another, and a function change unit configured to reflect the setting value of the particular function item to the function application table.

### [ADVANTAGEOUS EFFECTS]

With a data collection apparatus mounted on a vehicle and a function changing method of the data collection apparatus according to an embodiment disclosed herein, a function of the data collection apparatus may be changed in real time even without firmware update.

Moreover, various effects recognized directly or indirectly from the disclosure may be provided.

### [DESCRIPTION OF DRAWINGS]

FIG. 1 is a block diagram of a system according to an embodiment disclosed herein.
FIG. 2 is a block diagram showing in detail a data collection apparatus shown in FIG. 1.
FIG. 3 is a flowchart for describing a function changing method of a data collection apparatus according to an embodiment of the present disclosure.
FIG. 4 is a view showing examples of a function application table stored in a data collection apparatus and an device function table stored in a cloud server.
FIG. 5 is a block diagram showing a hardware configuration of a computing system for performing an operating method of a system, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

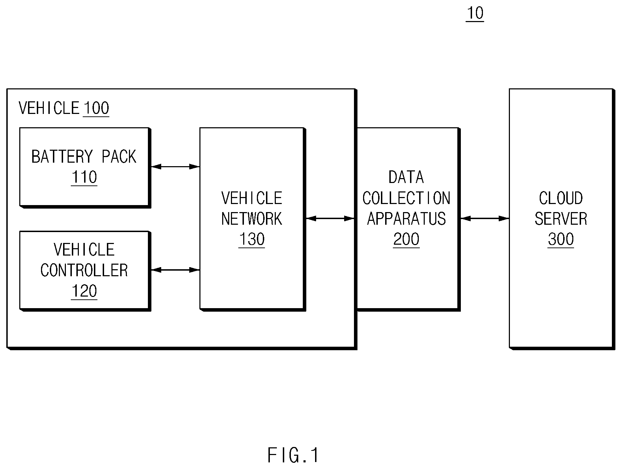

FIG. 1 is a block diagram of a system according to an embodiment disclosed herein.

Referring to FIG. 1, a system 10 according to an embodiment according to the present disclosure may include a vehicle 100, a data collection apparatus 200, and a cloud server 300.

The vehicle 100 may be an electric vehicle (EV) supplied with a driving force from a battery that stores power, but the scope of the present disclosure may not be limited thereto and the technical spirit of the present disclosure may be applied to electric transportation means (e.g., electric scooters, etc.) other than the vehicle 100.

The vehicle100 may include a battery pack 110, a vehicle controller 120, and a vehicle network 120.

The battery pack 110 may include a battery that stores power required for driving the vehicle 100 and a battery management system (BMS) for controlling an operation of the battery. The BMS may control charging/discharging of the battery and transmit battery state data including at least one of data obtained by sensing a state of the battery (e.g., voltage, current, resistance, temperature, etc., of the battery) and data generated by processing the obtained data (e.g., a state of charge (SoC), a state of health (SoH), etc.) to the vehicle network 130. The vehicle controller 120 may communicate with another device inside or outside the vehicle 100 through the vehicle network 130.

The vehicle controller 120 may control the overall operation of the vehicle 100 by controlling the battery pack 110, at least one sensor (e.g., a radar sensor, a temperature sensor) provided on the vehicle 100, and at least one control device (e.g., a driving device, a brake, a steering device, an automated driving system (ADS), a telematics multimedia system (TMS)). According to another embodiment, the vehicle controller 120 may mean an electronic control unit (ECU) for controlling some components of the vehicle 100.

The vehicle network 130 may provide a communication environment where internal components of the vehicle 100 are capable of transmitting and receiving data to and from each other. The vehicle network 130 may be a controller area network (CAN) where internal components of the vehicle 100 connected in parallel are capable of communicating with each other without a host, but the scope of the present disclosure is not limited thereto. The vehicle network 130 may provide an environment where an external device (e.g., the data collection apparatus 200) is allowed to access and communicate with another device (e.g., the battery pack 110) through the vehicle network 130.

The data collection apparatus 200 may be mounted on the vehicle 100 to access the vehicle network 130, and may be, for example, an on-board diagnostics (OBD) device connected to an OBD port provided in the vehicle 100. The data collection apparatus 200 may access the vehicle network 130 and transmit and receive unified diagnostic service (UDS) data to obtain vehicle state information regarding a state of the vehicle 100 from the internal components of the vehicle 100. Herein, the vehicle state information may include speed data, driving distance data, driving time data, driving location data, and battery state data of the vehicle 100. The data collection apparatus 200 may transmit the vehicle state information to the cloud server 300.

The data collection apparatus 200 may control a component (e.g., software or hardware components) of the data collection apparatus 200 by executing at least one software installed in the data collection apparatus 200, and perform various data processing or operations. At least one software may include firmware. However, this is merely an example, and various embodiments are not limited thereto. For example, software for controlling a component of the data collection apparatus 200 may include an application program.

The data collection apparatus 200 may store and/or install firmware provided from the cloud server 300. According to an embodiment, the data collection apparatus 200 may determine a type of the vehicle 100 currently connected thereto, transmit vehicle information regarding the determined type to the cloud server 300, and receive firmware corresponding to vehicle type information from the cloud server 300 to perform an update operation for previously installed version firmware. A timepoint at which new firmware is applied to the data collection apparatus 200 by a firmware update operation may be a timepoint at which the data collection apparatus 200 enters a wakeup mode from a sleep mode after entering the sleep mode. Herein, the sleep mode may be a mode where the data collection apparatus 200 performs its minimum function (e.g., a function of receiving a wakeup request for entering a normal mode where the data collection apparatus 200 performs the main function) without performing its main function, such as turning-off of the vehicle 100.

At least one function of the data collection apparatus 200 may be changed through firmware update. The data collection apparatus 200 according to an embodiment of the present disclosure may perform function change through simple information change based on communication with the cloud server 300, instead of firmware update. In this case, the function change may be performed immediately without a process of waking up from the sleep mode.

The cloud server 300 may receive the vehicle state information from the data collection apparatus 200 by transmitting and receiving data to and from the data collection apparatus 200, and provide a management service for the vehicle 100 or the battery pack 110 by storing and analyzing the vehicle state information. In addition, the cloud server 300 may provide firmware to be installed in the data collection apparatus 200 at the request of the data collection apparatus 200.

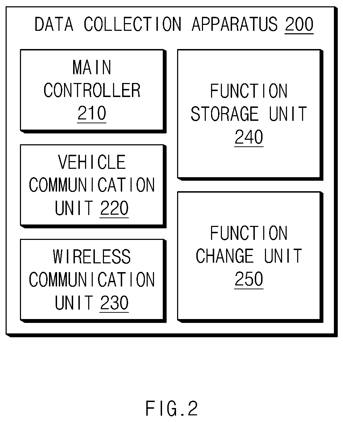

FIG. 2 is a block diagram showing in detail a data collection apparatus shown in FIG. 1.

Referring to FIG. 2, the data collection apparatus 200 may include a main controller 210, a vehicle communication unit 220, a wireless communication unit 230, a function storage unit 240, and a function change unit 250. Each component of the data collection apparatus 200 may be implemented with software, hardware, or a combination thereof.

The main controller 210 may control the data collection apparatus 200 to perform the operation of the data collection apparatus 200 described with reference to FIG. 1. The main controller 210 may perform a plurality of preset functions of the data collection apparatus 200, and refer to the function storage unit 240 to perform a corresponding function according to an application value corresponding to the function, stored in the function storage unit 240 when performing the plurality of functions. For example, the function storage unit 240 may store an application value (e.g., 1 second) corresponding to a monitoring period for obtaining the vehicle state information about the state of the vehicle 100 from the internal components of the vehicle 100, and the main controller 210 may perform a monitoring operation to obtain the vehicle state information for a period of 1 second according to the application value (e.g., 1 second) corresponding to the monitoring period stored in the function storage unit 240.

The vehicle communication unit 220 access the vehicle network 130 to transmit and receive data to and from an internal component (e.g., 110, 120, etc.) of the vehicle 100. The vehicle communication unit 220 may access the vehicle network 130 according to a communication scheme (or standards) determined based on the firmware installed in the data collection apparatus 200.

The wireless communication unit 230 may transmit and receive data to and from the cloud server 300. The wireless communication unit 230 may establish a wired communication channel between the data collection apparatus 200 and the cloud server 300, and transmit and receive data to and from the cloud server 300 through the established communication channel. For example, the wireless communication unit 230 may transmit data to and receive data from another device based on at least one radio access technology (RAT).

The function storage unit 240 may store an application value corresponding to each of the plurality of preset functions of the data collection apparatus 200. According to an embodiment, the function storage unit 240 may store an application value in the form of a table where each function and an application corresponding thereto are matched to each other, but the scope of the present disclosure is not limited thereto. In the present disclosure, the table where the functions and the application values are matched to each other will be defined as a function application table.

The function storage unit 240 may be referred to by the main controller 210 to provide an application value such that a corresponding function may be performed according to the application value stored in the function storage unit 240. At least one application value of the function storage unit 240 may be stored and/or changed in firmware update of the data collection apparatus 200 or may be changed by an operation of the function change unit 250.

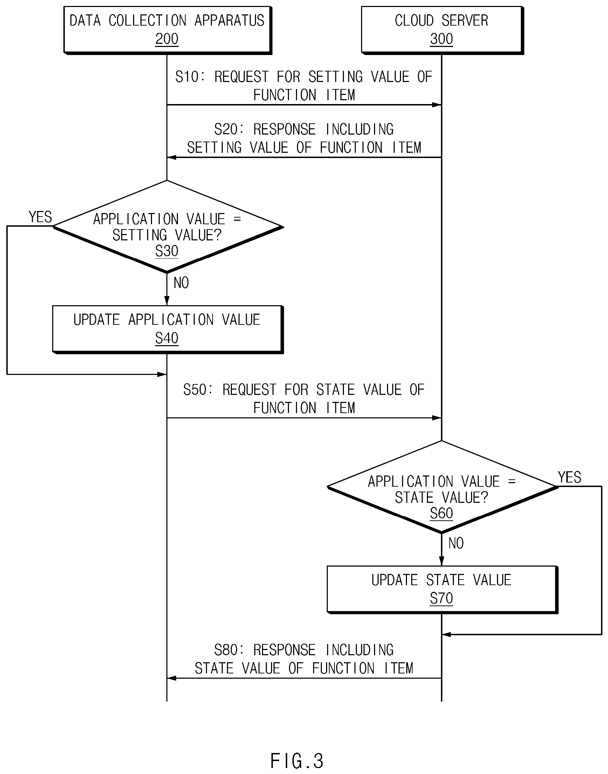

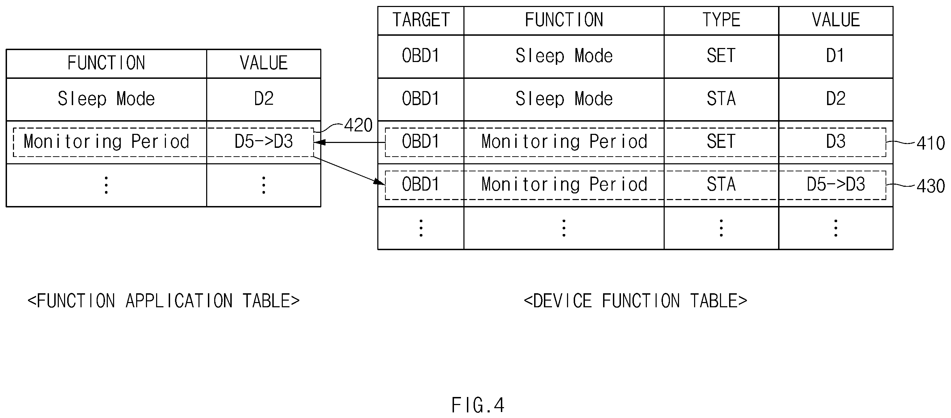

The function change unit 250 may change at least one application value stored in the function storage unit 240. According to an embodiment, the function change unit 250 may change at least one application value stored in the function storage unit 240 through communication with the cloud server 300. In this case, the function change unit 250 may change a function of the data collection apparatus 200 regardless of firmware update by changing a corresponding application value of the function application table. A detailed operation related thereto will be described later with reference to FIGS. 3 and 4.

FIG. 3 is a flowchart for describing a function changing method of a data collection apparatus according to an embodiment of the present disclosure. FIG. 4 is a view showing examples of a function application table stored in a data collection apparatus and an device function table stored in a cloud server.

Referring to FIGS. 3 and 4, the data collection apparatus 200 may immediately change a function of the data collection apparatus 200 without firmware update by operating with the cloud server 300.

Referring to FIG. 4, the data collection apparatus 200 may store a function application table where a function item indicating a function performed by the data collection apparatus 200 and an application value item corresponding to a function are matched to each other. The matched function item and application value item may be defined as function application data. That is, the function application table may be a set of the function application data. For example, an application value item of the function application data for a mode (e.g., a sleep mode entry time, a sleep mode period, etc.) of the sleep mode may be D2, and the data collection apparatus 200 may operate in the sleep mode with a mode corresponding to D2.

Meanwhile, the cloud server 300 may store a device function table in which a target item indicating identification information of the data collection apparatus, a function item, a type item indicating a data type, and a setting value/state value item corresponding to a function are matched. Herein, the setting value may mean a value for the cloud server 300 to set a function of the data collection apparatus 200, and the state value may mean a value with which a function of the data collection apparatus 200 is currently set. The type item may include a first type SET corresponding to the setting value or a second type STA corresponding to the state value. A value (e.g., D1) matched to the first type SET may correspond to the setting value, and a value (e.g., D2) matched to the second type STA may correspond to the state value. Moreover, there may be a plurality of data collection apparatuses managed by the cloud server 300, and a target item may be included in the device function table to identify a data collection apparatus corresponding to the setting value or the state value. For example, the identification information of the data collection apparatus 200 may be OBD1, and each of function setting data and function state data for the data collection apparatus 200 may have OBD1 in the target item.

The matched target item, function item, type item, and setting value item may be defined as the function setting data. The matched target item, function item, type item, and state value item may be defined as the function state data. That is, the device function table may be a set of the function setting data and the function state data.

The cloud server 300 may operate the function setting data for each data collection apparatus, and set the function setting data corresponding to individual conditions such as characteristics (e.g., specifications) of the data collection apparatus, characteristics (e.g., a driving habit, a battery charging habit) of a driver of a vehicle having mounted thereon the data collection apparatus, etc.

In FIG. 3, the data collection apparatus 200 may transmit a request for a setting value of a particular function item to the cloud server 300, in operation S10. For example, the data collection apparatus 200 may transmit a request for a setting value of a monitoring period to the cloud server 300.

The cloud server 300 may transmit a response including the setting value of the particular function item to the data collection apparatus 200 in response to the request for the setting value of the particular function item, received from the data collection apparatus 200, in operation S20. For example, after receiving the request for the setting value of the monitoring period from the data collection apparatus 200, the cloud server 300 may search for "OBD1" corresponding to the data collection apparatus 200 from the target item, "Monitoring Period" corresponding to the monitoring period from the function item, and "SET" corresponding to the setting value from the type item, by referring to the device function table. The cloud server 300 may determine a setting value D3 of the function setting data 410, including "OBD1", "Monitoring Period", and "SET", as a setting value of the monitoring period corresponding to the data collection apparatus 200, and transmit a response including D3 to the data collection apparatus 200.

The data collection apparatus 200 may compare a setting value of the particular function item, included in the response of the cloud server 300, with an application value of the particular function item, stored in the data collection apparatus 200. For example, the data collection apparatus 200 may compare the setting value of the monitoring period with an application value of the monitoring period, stored in the data collection apparatus 200.

When the setting value of the particular function item is different from the application value of the particular function item (No in operation S30), the data collection apparatus 200 may update the application value of the particular function item into the setting value of the particular function item. For example, when the setting value of the monitoring period is D3 and the application value of the monitoring period is D5, such that they are different from each other, as shown in FIG. 4, the data collection apparatus 200 may update an application value of a monitoring period of function application data 420 from D5 into D3.

When the setting value of the particular function item and the application value of the particular function item are the same as each other (Yes in operation S30), the data collection apparatus 200 may not update the application value of the particular function item. This is because a value set by the cloud server 300 for the particular function item of the data collection apparatus 200 is already applied to the data collection apparatus 200.

Operations S30 and S40 may mean operations of reflecting the setting value of the particular function item, included in the response of the cloud server 300, to the function application table stored in the data collection apparatus 200. Through these operations, function change of the data collection apparatus 200 may be performed in real time without firmware update.

After an operation corresponding to the response including the setting value of the particular function item is completed, the data collection apparatus 200 may transmit a request for a state value of the particular function item to the cloud server 300, in operation S50. The request for the state value of the particular function item may include an application value of the particular function item, currently stored in the data collection apparatus 200.

The cloud server 300 may compare the application value of the particular function item, included in the request of the data collection apparatus 200, with the state value of the particular function item, stored in the cloud server 300.

For example, the cloud server 300 may compare the application value of the monitoring period with the state value of the monitoring period, stored in the cloud server 300. After receiving the application value of the monitoring period from the data collection apparatus 200, the cloud server 300 may search for "OBD1" corresponding to the data collection apparatus 200 from the target item, "Monitoring Period" corresponding to the monitoring period from the function item, and "STA" corresponding to the state value from the type item, by referring to the device function table. The cloud server 300 may compare a state value of function state data 430 including "OBD1", "Monitoring Period", and "STA" with the application value of the monitoring period, received from the data collection apparatus 200.

When the application value of the particular function item is different from the state value of the particular function item (No in operation S60), the cloud server 300 may update the state value of the particular function item into the application value of the particular function item, in operation S70. For example, when the application value of the monitoring period is D3 and the state value of the monitoring period is D5, such that they are different from each other, as shown in FIG. 4, the cloud server 300 may update the state value of the monitoring period of the function state data 430 from D5 into D3.

When the application value of the particular function item and the state value of the particular function item are the same as each other (Yes in operation S60), the cloud server 300 may not update the state value of the particular function item. This is because the state value of the particular function item already reflects the application value of the particular function item of the data collection apparatus 200.

Operations S60 and S70 may mean operations of reflecting the application value of the particular function item, included in the request of the data collection apparatus 200, to the function state data of the device function table stored in the cloud server 300. Through these operations, monitoring of a function change result of the data collection apparatus 200 and a currently applied function may be performed.

The cloud server 300 may transmit a response including the state value of the particular function item to the data collection apparatus 200, in operation S80.

In the above-described method, the operations of the data collection apparatus 200 may be mainly performed by the wireless communication unit 230 and the function change unit 250 of the data collection apparatus 200.

The operations described with reference to FIG. 3 may be described as an example for one particular function item, and for various functions of the data collection apparatus 200, a function change operation may be sequentially performed in substantially the same manner as the operations described with reference to FIG. 3. An order (i.e., for which function the function change operation is to be performed first) and/or a period (how frequently the function change operation is to be performed on the corresponding function) of the function change operation for each function may be predetermined and stored in the data collection apparatus 200.

With the function changing method of the data collection apparatus according to an embodiment of the present disclosure, to change a particular function of the data collection apparatus 200, the cloud server 300 may change the particular function of the data collection apparatus 200 by changing a setting value corresponding to the particular function of the data collection apparatus 200 in the device function table, without firmware update.

When a function of the data collection apparatus 200 is changed through firmware update, the same firmware is applied to the same model, such that function change is not possible for each data collection apparatus according to an individual condition such as characteristics of a driver. However, with the function changing method of the data collection apparatus according to an embodiment of the present disclosure, the cloud server 300 may independently change a particular function of the data collection apparatus for each data collection apparatus according to an individual condition such as characteristics of a driver.

The cloud server 300 may analyze vehicle state information received from the data collection apparatus 200 to determine whether function change of the data collection apparatus 200 is required, change a setting value corresponding to the particular function of the data collection apparatus 200 in the device function table when change of the particular function is required, and change the function of the data collection apparatus 200 in real time as the operations shown in FIG. 3 are performed.

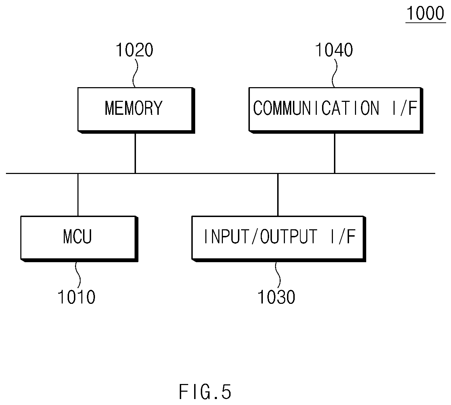

FIG. 5 is a block diagram showing a hardware configuration of a computing system for performing an operating method of a system, according to an embodiment disclosed herein.

Referring to FIG. 5, a computing system 1000 according to an embodiment disclosed herein may include a microcontroller unit (MCU) 1010, a memory 1020, an input/output interface (I/F) 1030, and a communication I/F 1040.

According to an embodiment, the computing system 1000 may be a system for performing an operation of each component (e.g., the data collection apparatus 200, the cloud server 300, etc., hereinafter, referred to as a 'corresponding device') of the above-described system 10.

The MCU 1020 may be a processor that executes various programs stored in the memory 1020.

For example, the MCU 1020 may be a processor for processing various data and/or signals required for performing the operation of the processing controller 200.

The memory 1020 may store various programs and/or data required for managing and controlling the corresponding device. The memory 1020 may be provided in plural, depending on a need.

The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from external components including a server, may be various devices capable of supporting wired or wireless communication.

As such, a computer program according to an embodiment disclosed herein may be recorded in the memory 1020 and executed and processed by the MCU 1010, thus being implemented as a module that performs functions shown in FIGS. 1 to 3.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A function changing method of a data collection apparatus mounted on a vehicle, the function changing method comprising:
receiving, from the data collection apparatus, a request for a setting value of a particular function item indicating one of functions of the data collection apparatus;
searching for the setting value of the particular function item by referring to a device function table; and
transmitting, to the data collection apparatus, a response comprising the setting value of the particular function item.

2. The function changing method of claim 1, wherein the device function table comprises function setting data where a target item indicating identification information of the data collection apparatus, a function item comprising the particular function item, a type item indicating a type of data, and a setting value of the function item are matched to one another.

3. The function changing method of claim 2, wherein the searching for the setting value of the particular function item comprises:
searching for the identification information of the data collection apparatus in the target item;
searching for the particular function item in the function item; and
searching for a first type indicating a setting value in the type item.

4. The function changing method of claim 1, further comprising:
receiving, from the data collection apparatus, a request for a state value of the particular function item; and
searching for the state value of the particular function item by referring to the device function table.

5. The function changing method of claim 4, wherein the device function table comprises function state data where a target item indicating identification information of the data collection apparatus, a function item comprising the particular function item, a type item indicating a type of data, and a state value of the function item are matched to one another.

6. The function changing method of claim 5, wherein the searching for the state value of the particular function item comprises:
searching for the identification information of the data collection apparatus in the target item;
searching for the particular function item in the function item; and
searching for a second type indicating a state value in the type item.

7. The function changing method of claim 4, wherein the request for the state value of the particular function item comprises an application value of the particular function item, stored in the data collection apparatus.

8. The function changing method of claim 7, further comprising:
comparing the application value of the particular function item with the state value of the particular function item, stored in the device function table; and
updating the state value of the particular function item into the application value of the particular function item, when the application value of the particular function item and the state value of the particular function item are different from each other.

9. The function changing method of claim 1, further comprising:
analyzing vehicle state information received from the data collection apparatus to determine whether function change of the particular function item of the data collection apparatus is required; and
changing a setting value corresponding to the particular function item of the data collection apparatus in the device function table, when the function change is required.

10. A function changing method of a data collection apparatus mounted on a vehicle, the function changing method comprising:
transmitting, to a server managing the data collection apparatus, a request for a setting value of a particular function item indicating one of functions of the data collection apparatus;
receiving, from the server, a response comprising the setting value of the particular function item; and
reflecting the setting value of the particular function item to a function application table.

11. The function changing method of claim 10, wherein the function application table comprises function state data where a target item indicating identification information of the data collection apparatus, a function item comprising the particular function item, and an application value of the function item are matched to one another.

12. The function changing method of claim 11, further comprising:
comparing the setting value of the particular function item with the application value of the particular function item, stored in the function application table; and
updating the application value of the particular function item into the setting value of the particular function item, when the setting value of the particular function item and the application value of the particular function item are different from each other.

13. The function changing method of claim 11, further comprising performing a function corresponding to the particular function item by referring to the application value of the particular function item, stored in the function application table.

14. A data collection apparatus mounted on a vehicle, the data collection apparatus comprising:
a wireless communication unit configured to transmit, to a server managing the data collection apparatus, a request for a setting value of a particular function item indicating one of functions of the data collection apparatus, and receive, from the server, a response comprising the setting value of the particular function item;
a function storage unit configured to store a function application table comprising function state data where a target item indicating identification information of the data collection apparatus, a function item comprising the particular function item, and an application value of the function item are matched to one another; and
a function change unit configured to reflect the setting value of the particular function item to the function application table.
